(19) Europäisches Patentamt
European Patent Office
Office européen des brevets

(11) EP 3 598 863 A1

(12) **EUROPEAN PATENT APPLICATION**
published in accordance with Art. 153(4) EPC

(43) Date of publication:
**22.01.2020 Bulletin 2020/04**

(21) Application number: **18767722.4**

(22) Date of filing: **12.03.2018**

(51) Int Cl.:
***H05K 9/00*** *(2006.01)*

(86) International application number:
**PCT/JP2018/009549**

(87) International publication number:
**WO 2018/168786 (20.09.2018 Gazette 2018/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.03.2017 JP 2017047255**

(71) Applicant: **FUJIFILM Corporation**
**Tokyo 106-8620 (JP)**

(72) Inventor: **KAWAGUCHI Junji**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

# (54) ELECTROMAGNETIC WAVE SHIELD MEMBER

(57) Provided is an electromagnetic wave shielding member which has high shielding properties against electromagnetic waves in the GHz band and is transmissive to electromagnetic waves in the ultraviolet region to the mid-infrared region. The electromagnetic wave shielding member of the present invention is an electromagnetic wave shielding member including a metal foil formed with a plurality of through-holes penetrating therethrough in a thickness direction, in which the through-holes have an average opening diameter of 1 μm to 100 μm and an average opening ratio of 1% to 50%; in a case where the average opening diameter of the through-holes is 1 μm to 1.5 μm, the transmittance with respect to electromagnetic waves up to a wavelength of half the length of the opening diameter of the through-holes from the ultraviolet region to the visible region is 10% or more of the opening ratio; in a case where the opening diameter of the through-holes is 1.5 μm to 5 μm, the transmittance with respect to electromagnetic waves from the ultraviolet region to the visible region is in a range of -5% to +5% of the opening ratio of the through-holes, and the transmittance with respect to electromagnetic waves up to a wavelength of half the length of the opening diameter of the through-holes in the near-infrared region is 10% or more of the opening ratio; and in a case where the opening diameter of the through-holes is 5 μm or more, the transmittance with respect to electromagnetic waves from the ultraviolet region to the near-infrared region is in a range of -5% to +5% of the opening ratio of the through-holes, and the transmittance with respect to electromagnetic waves up to a wavelength of half the length of the opening diameter of the through-holes in the mid-infrared region is 10% or more of the average opening ratio.

FIG. 1

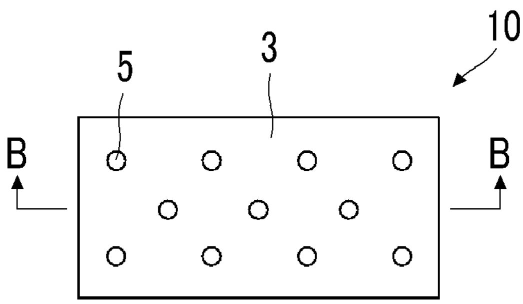


EP 3 598 863 A1

## Description

### BACKGROUND OF THE INVENTION

1. Field of the Invention

The present invention relates to an electromagnetic wave shielding member.

2. Description of the Related Art

In recent years, with the expansion of demand for communication devices such as mobile phones, the use frequency band of communication using electromagnetic waves has been expanded. Specifically, application studies from the conventional MHz band to the GHz band are in progress.

Along with this, there is a need for an electromagnetic wave shielding member having high shielding properties against electromagnetic waves in the GHz band.

For example, JP1999-177277A (JP-H11-177277A) discloses an electromagnetic wave shielding wallpaper in which a wallpaper backing paper layer made of a thin paper and an intermediate peelable paper is provided at least on the back side of an aluminum foil through an adhesive layer, and insertion holes by needle-like projections are provided in the wallpaper backing paper layer ([claim 1]).

JP1999-177277A (JP-H11-177277A) discloses that the electromagnetic wave shielding wallpaper exhibits electromagnetic wave shielding properties of 50 dB or more in a frequency band of 1 GHz to 8 GHz ([Table 1]).

By the way, in an electronic device having a display device or the like, there is a need for an electromagnetic wave shielding member that shields electromagnetic waves in a communication frequency band in order to suppress external electric field waves from entering the electronic device and becoming noise sources and is transmissive to electromagnetic waves in the visible light range.

For example, JP2009-243138A discloses an electromagnetic wave shielding laminate in which a layer (A) made of a metal and a dielectric is provided on one side of a transparent thermoplastic resin film, and a metal layer (B) is provided on the other side thereof, in which the coverage of the metal portion to the film area in the metal layer (B) plane is 20% to 80%, the ratio of the visible light transmittance (Tvis) to the near infrared transmittance (Tnir) of the laminate (Tnir/Tvis) is 0.75 or less, and the electric wave shielding properties in the frequency band of 80 MHz to 1000 MHz are 30 dB or more ([claim 1]).

### SUMMARY OF THE INVENTION

Here, in a case of electromagnetic waves in the MHz band, high shielding properties can be obtained by using a metallic shielding member having a large through-hole such as a wire mesh. Therefore, the transmittivity in the visible light region can be increased.

However, with regard to electromagnetic waves in the GHz band, high shielding properties cannot be obtained with a shielding member having a large through-hole such as a metal mesh, so there is a problem that it is not possible to simultaneously achieve high shielding properties and the transmittivity of electromagnetic waves in ultraviolet region, visible light region, near-infrared region, and mid-infrared region.

Therefore, an object of the present invention is to provide an electromagnetic wave shielding member which has high shielding properties against electromagnetic waves in the GHz band and is transmissive to electromagnetic waves in the ultraviolet region to the mid-infrared region.

As a result of extensive studies to achieve the foregoing object, the present inventors have found that the foregoing object can be achieved by a configuration that the electromagnetic wave shielding member comprises a metal foil formed with a plurality of through-holes penetrating therethrough in a thickness direction, in which the through-holes have an average opening diameter of 1 μm to 100 μm and an average opening ratio of 1% to 50%, in a case where the average opening diameter of the through-holes is 1 μm or more and less than 1.5 μm, the transmittance with respect to electromagnetic waves up to a wavelength of half the length of the average opening diameter of the through-holes from an ultraviolet region to a visible region is 10% or more of the average opening ratio, in a case where the average opening diameter of the through-holes is 1.5 μm or more and less than 5 μm, the transmittance with respect to electromagnetic waves from the ultraviolet region to the visible region is in a range of absolute value -5% to +5% of the average opening ratio of the through-holes, the transmittance with respect to electromagnetic waves up to a wavelength of half the length of the average opening diameter of the through-holes in a near-infrared region is 10% or more of the average opening ratio, in a case where the average opening diameter of the through-holes is 5 μm or more, the transmittance with respect to electromagnetic waves from the ultraviolet region to the near-infrared region is in a range of absolute value -5% to +5% of the average opening ratio of the through-holes, and the transmittance with respect to electromagnetic

waves up to a wavelength of half the length of the average opening diameter of the through-holes in a mid-infrared region is 10% or more of the average opening ratio. The present invention has been completed based on these findings.

That is, the present inventors have found that the foregoing object can be achieved by the following configurations.

[1] An electromagnetic wave shielding member comprising:

a metal foil formed with a plurality of through-holes penetrating therethrough in a thickness direction,
in which the through-holes have an average opening diameter of 1 μm to 100 μm and an average opening ratio of 1% to 50%,
in a case where the average opening diameter of the through-holes is 1 μm or more and less than 1.5 μm,
the transmittance with respect to electromagnetic waves up to a wavelength of half the length of the average opening diameter of the through-holes from an ultraviolet region to a visible region is 10% or more of the average opening ratio,
in a case where the average opening diameter of the through-holes is 1.5 μm or more and less than 5 μm,
the transmittance with respect to electromagnetic waves from the ultraviolet region to the visible region is in a range of absolute value -5% to +5% of the average opening ratio of the through-holes,
the transmittance with respect to electromagnetic waves up to a wavelength of half the length of the average opening diameter of the through-holes in a near-infrared region is 10% or more of the average opening ratio,
in a case where the average opening diameter of the through-holes is 5 μm or more,
the transmittance with respect to electromagnetic waves from the ultraviolet region to the near-infrared region is in a range of absolute value -5% to +5% of the average opening ratio of the through-holes, and
the transmittance with respect to electromagnetic waves up to a wavelength of half the length of the average opening diameter of the through-holes in a mid-infrared region is 10% or more of the average opening ratio.

[2] The electromagnetic wave shielding member according to [1], in which the metal foil has a thickness of 5 μm to 1000 μm.

[3] The electromagnetic wave shielding member according to [1] or [2], in which the metal foil is a foil selected from the group consisting of an aluminum foil, a copper foil, a silver foil, a gold foil, a platinum foil, a stainless steel foil, a titanium foil, a tantalum foil, a molybdenum foil, a niobium foil, a zirconium foil, a tungsten foil, a beryllium copper foil, a phosphor blue copper foil, a brass foil, a nickel silver foil, a tin foil, a lead foil, a zinc foil, a solder foil, an iron foil, a nickel foil, a permalloy foil, a nichrome foil, a 42 alloy foil, a kovar foil, a monel foil, an inconel foil, and a hastelloy foil, or a foil obtained by laminating a foil selected from this group and a metal different from the selected foil.

As will be described below, according to the present invention, there is provided an electromagnetic wave shielding member that has high shielding properties against electromagnetic waves in the GHz band and is transmissive to electromagnetic waves in the ultraviolet region to the mid-infrared region.

**BRIEF DESCRIPTION OF THE DRAWINGS**

Fig. 1 is a top view schematically showing an example of an electromagnetic wave shielding member of the present invention.
Fig. 2 is a cross-sectional view schematically showing an example of the electromagnetic wave shielding member shown in Fig. 1.
Fig. 3 is a schematic cross-sectional view for explaining an example of a suitable method for producing the electromagnetic wave shielding member of the present invention.
Fig. 4 is a schematic cross-sectional view for explaining an example of a suitable method for producing the electromagnetic wave shielding member of the present invention.
Fig. 5 is a schematic cross-sectional view for explaining an example of a suitable method for producing the electromagnetic wave shielding member of the present invention.
Fig. 6 is a schematic cross-sectional view for explaining an example of a suitable method for producing the electromagnetic wave shielding member of the present invention.
Fig. 7 is a schematic cross-sectional view for explaining another example of the method for producing the electromagnetic wave shielding member of the present invention.
Fig. 8 is a schematic cross-sectional view for explaining another example of the method for producing the electromagnetic wave shielding member of the present invention.

Fig. 9 is a schematic cross-sectional view for explaining another example of the method for producing the electromagnetic wave shielding member of the present invention.

Fig. 10 is a schematic cross-sectional view for explaining another example of the method for producing the electromagnetic wave shielding member of the present invention.

Fig. 11 is a schematic view for explaining a method for measuring shielding properties.

## DESCRIPTION OF THE PREFERRED EMBODIMENTS

Hereinafter, the present invention will be described in detail.

Although the description of the constitutive elements described below may be made based on the representative embodiments of the present invention, the present invention is not limited to such embodiments.

In the present specification, a numerical range represented using "to" means a range including numerical values described before and after "to" as the lower limit value and the upper limit value, respectively.

[Electromagnetic wave shielding member]

The electromagnetic wave shielding member according to the embodiment of the present invention is
an electromagnetic wave shielding member comprising a metal foil formed with a plurality of through-holes penetrating therethrough in a thickness direction,
in which the through-holes have an average opening diameter of 1 μm to 100 μm and an average opening ratio of 1% to 50%,
in a case where the average opening diameter of the through-holes is 1 μm or more and less than 1.5 μm,
the transmittance with respect to electromagnetic waves up to a wavelength of half the length of the average opening diameter of the through-holes from an ultraviolet region to a visible region is 10% or more of the average opening ratio,
in a case where the average opening diameter of the through-holes is 1.5 μm or more and less than 5 μm,
the transmittance with respect to electromagnetic waves from the ultraviolet region to the visible region is in a range of absolute value -5% to +5% of the average opening ratio of the through-holes,
the transmittance with respect to electromagnetic waves up to a wavelength of half the length of the average opening diameter of the through-holes in a near-infrared region is 10% or more of the average opening ratio,
in a case where the average opening diameter of the through-holes is 5 μm or more,
the transmittance with respect to electromagnetic waves from the ultraviolet region to the near-infrared region is in a range of absolute value -5% to +5% of the average opening ratio of the through-holes, and
the transmittance with respect to electromagnetic waves up to a wavelength of half the length of the average opening diameter of the through-holes in a mid-infrared region is 10% or more of the average opening ratio.

Next, the configuration of the electromagnetic wave shielding member according to the embodiment of the present invention will be described with reference to Fig. 1.

Fig. 1 is a schematic plan view showing an example of a suitable embodiment of the electromagnetic wave shielding member according to the embodiment of the present invention. Fig. 2 is a cross-sectional view taken along a line B-B of Fig. 1.

An electromagnetic wave shielding member 10 shown in Figs. 1 and 2 has a plurality of through-holes 5 penetrating a metal foil 3 in a thickness direction.

Here, in the electromagnetic wave shielding member according to the embodiment of the present invention, the through-holes formed in the metal foil have an average opening diameter of 1 μm to 100 μm and an average opening ratio of 1% to 50%, in a case where the average opening diameter of the through-holes is 1 μm or more and less than 1.5 μm, the transmittance with respect to electromagnetic waves up to a wavelength of half the length of the average opening diameter of the through-holes from the ultraviolet region to the visible region is 10% or more of the average opening ratio, in a case where the average opening diameter of the through-holes is 1.5 μm or more and less than 5 μm, the transmittance with respect to electromagnetic waves from the ultraviolet region to the visible region is in a range of absolute value -5% to +5% of the average opening ratio of the through-holes, the transmittance with respect to electromagnetic waves up to a wavelength of half the length of the average opening diameter of the through-holes in the near-infrared region is 10% or more of the average opening ratio, in a case where the average opening diameter of the through-holes is 5 μm or more, the transmittance with respect to electromagnetic waves from the ultraviolet region to the near-infrared region is in a range of absolute value -5% to +5% of the average opening ratio of the through-holes, and the transmittance with respect to electromagnetic waves up to a wavelength of half the length of the average opening diameter of the through-holes in the mid-infrared region is 10% or more of the average opening ratio.

As described above, with regard to electromagnetic waves in the GHz band, high shielding properties cannot be obtained with a shielding member having a large through-hole such as a metal mesh, so there is a problem that it is not possible to simultaneously achieve high shielding properties and the transmittivity of electromagnetic waves in

ultraviolet region, visible light region, near-infrared region, and mid-infrared region.

On the other hand, in the electromagnetic wave shielding member according to the embodiment of the present invention, through-holes having an average opening diameter and an average opening ratio in the above range are formed in a metal foil, and the transmittances in the ultraviolet region, the visible light region, the near-infrared region, and the mid-infrared region are set in the above-mentioned range in accordance with the average opening diameter of the through holes.

As a result, high shielding properties can be obtained against electromagnetic waves in the GHz band, and the transmittivity of the electromagnetic waves in the ultraviolet region, the visible light region, the near-infrared region, and the mid-infrared region can be secured.

Here, the average opening diameter of the through-hole is obtained as follows. The surface of the electromagnetic wave shielding member is photographed at a magnification of 100 to 10000 using a high resolution scanning electron microscope (SEM) from one surface of the electromagnetic wave shielding member. In the obtained SEM photograph, at least 20 through-holes whose circumference is continuous in an annular shape are extracted, and the diameters thereof are read to be the opening diameters. Then, the average value of these opening diameters is calculated as the average opening diameter.

In addition, the magnification of the range mentioned above can be suitably selected so that the SEM photograph which can extract 20 or more through-holes can be obtained. Moreover, the opening diameter is obtained by measuring the maximum value of the distance between the ends of the through-hole portion. That is, since the shape of the opening of the through-hole is not limited to a substantially circular shape, in a case where the shape of the opening is non-circular, the maximum value of the distance between the ends of the through-hole portions is taken as the opening diameter. Therefore, for example, even in a case of a through-hole having a shape in which two or more through-holes are integrated, this is regarded as one through-hole, and the maximum value of the distance between the ends of the through-hole portions is taken as the opening diameter.

In addition, the average opening ratio of the through-holes is obtained in such a manner that a parallel light optical unit is installed on one side of the electromagnetic wave shielding member, the parallel light is transmitted therethrough, and the surface of the electromagnetic wave shielding member is photographed at a magnification of 100 using an optical microscope from the other side of the electromagnetic wave shielding member to obtain a photograph. For the 100 mm $\times$ 75 mm visual field (5 places) in the range of 10 cm $\times$ 10 cm of the obtained photograph, from the sum of the opening area of the through-holes projected by the parallel light transmitted and the area (geometrical area) of the visual field, the ratio (opening area/geometrical area) is calculated, and the average value in each visual field (5 places) is calculated as an average opening ratio.

Further, in the present invention, the ultraviolet region to the visible light region is a band having a wavelength of 250 nm or more and less than 750 nm including the ultraviolet region and the visible light region. Further, the near-infrared region is a band having a wavelength of 750 nm or more and less than 2500 nm. Therefore, the ultraviolet region to the near-infrared region is a band having a wavelength of 250 nm or more and less than 2500 nm including the ultraviolet region, the visible light region, and the near-infrared region. In addition, the mid-infrared region is a band having a wavelength of 2500 nm or more and 18000 nm or less.

In addition, the electromagnetic wave transmittance can be obtained in such a manner that an electromagnetic wave of a specific frequency is transmitted in a shield box, the electromagnetic wave passing through the electromagnetic wave shielding member is received on the other side, and the ratio of the intensity of the electromagnetic wave after passing through the electromagnetic wave shielding member to the intensity of the electromagnetic wave before passing through the electromagnetic wave shielding member is determined.

The transmittance of the electromagnetic wave in each of the wavelength ranges described above is an average value of the transmittance of the electromagnetic waves in the corresponding wavelength range.

The electromagnetic waves in the GHz band are electromagnetic waves in the frequency band of 1 GHz to 18 GHz.

In the present invention, the average value of the electromagnetic wave shielding properties in the frequency band of 1 GHz to 18 GHz can be set to 60 dB or more.

Here, the electromagnetic wave shielding properties represent the ratio of the electric field strength before passing through the electromagnetic wave shielding member to the electric field strength after passing through the electromagnetic wave shielding member in terms of logarithm.

Here, the average opening diameter of the through-holes is preferably 1 $\mu$m or more and 45 $\mu$m or less, more preferably 1 $\mu$m or more and 40 $\mu$m or less, and still more preferably 1 $\mu$m or more and 30 $\mu$m or less.

By setting the average opening diameter of the through-holes in the above range, the electromagnetic wave shielding properties can be made more suitable. In addition, even in a case where the electromagnetic wave shielding member has a large number of through-holes, the shielding member can have sufficient tensile strength.

In addition, the average opening ratio of the through-holes is preferably 2% to 45%, more preferably 2% to 30%, and still more preferably 2% to 20%.

By setting the average opening ratio of the through-holes in the above range, the electromagnetic wave shielding properties can be made more suitable. In addition, even in a case where the electromagnetic wave shielding member has a large number of through-holes, the shielding member can have sufficient tensile strength.

[Metal foil]

The metal foil is not limited as long as it is a foil having high shielding properties against electromagnetic waves in the GHz band, but it is preferably a foil composed of a metal and/or a metal compound which can easily form the through-holes of the above-mentioned average opening diameter and average opening ratio and more preferably a foil composed of a metal. In addition, the metal foil is also preferably a metal foil containing a metal atom that dissolves in an etchant used in the through-hole forming step 2 which will be described later.

Specific examples of the metal foil include an aluminum foil, a copper foil, a silver foil, a gold foil, a platinum foil, a stainless steel foil, a titanium foil, a tantalum foil, a molybdenum foil, a niobium foil, a zirconium foil, a tungsten foil, a beryllium copper foil, a phosphor blue copper foil, a brass foil, a nickel silver foil, a tin foil, a lead foil, a zinc foil, a solder foil, an iron foil, a nickel foil, a permalloy foil, a nichrome foil, a 42 alloy foil, a kovar foil, a monel foil, an inconel foil, and a hastelloy foil.

In addition, the metal foil may be a laminate of two or more different metals including the above-mentioned types of metals.

The method of laminating the metal foil is not particularly limited, but is preferably plating or cladding. The metal used for plating is preferably a metal containing a metal atom that dissolves in an etchant, and is preferably a metal. Examples of plating species include nickel, chromium, cobalt, iron, zinc, tin, copper, silver, gold, platinum, palladium, and aluminum.

The method of plating is not particularly limited, and any of electroless plating, electrolytic plating, hot-dip plating, and chemical conversion treatment may be used.

In addition, the metal used to form the clad material for the metal foil is preferably a metal containing a metal atom that dissolves in an etchant. A metal species may be, for example, the metal used for the above-mentioned metal foil.

The average thickness of the metal foil is preferably 5 μm to 1000 μm. From the viewpoint of handleability, the average thickness of the metal foil is more preferably 5 μm to 50 μm and still more preferably 8 μm to 30 μm.

Here, the average thickness of the metal foil refers to an average value of the thickness measured at any five points using a contact film thickness meter (digital electronic micrometer).

<Aluminum>

The aluminum in a case of using aluminum as the metal foil is not particularly limited. For example, a known aluminum alloy such as 3000 series (for example, aluminum alloy 3003) or 8000 series (for example, aluminum alloy 8021) can be used.

For example, an aluminum alloy having an alloy number shown in Table 1 below can be used as such an aluminum alloy.

[Table 1]

| Alloy No. | Si (% by mass) | Fe (% by mass) | Cu (% by mass) |
|---|---|---|---|
| 1085 | 0.02 | 0.04 | <0.01 |
| 1N30 | 0.11 | 0.45 | 0.02 |
| 8021 | 0.04 | 1.44 | <0.01 |
| 3003 | 0.60 | 0.70 | 0.10 |

[Method for producing electromagnetic wave shielding member]

Next, the method for producing the electromagnetic wave shielding member according to the embodiment of the present invention will be described.

The method for producing an electromagnetic wave shielding member is not particularly limited. In a case where an aluminum substrate is used as the metal foil, there is, for example, a method including a film forming step of forming an aluminum hydroxide film on at least one surface of an aluminum substrate, a through-hole forming step 1 of carrying

out a through-hole forming treatment after the film forming step to form through-holes, a film removing step of removing the aluminum hydroxide film after the through-hole forming step 1, and a resin layer forming step of forming a resin layer on at least one surface of an aluminum substrate having through-holes after the film removing step.

Hereinafter, individual steps of the method for producing an electromagnetic wave shielding member (hereinafter, also referred to as first production method) in a case of using an aluminum substrate as the metal foil will be described with reference to Figs. 3 to 6, and then the individual steps will be described in detail.

Figs. 3 to 6 are schematic cross-sectional views showing an example of a suitable embodiment of the method for producing an electromagnetic wave shielding member.

As shown in Figs. 3 to 6, the first production method is a production method including a film forming step of carrying out a film forming treatment on both surfaces of the aluminum substrate 1 to form an aluminum hydroxide film 2 (Figs. 3 and 4); a through-hole forming step 1 of carrying out an electrolytic dissolution treatment after the film forming step to form through-holes 5 and producing a laminate having an aluminum substrate 3 having through-holes and an aluminum hydroxide film 4 having through-holes (Figs. 4 and 5); and a film removing step of removing the aluminum hydroxide film 4 having through-holes after the through-hole forming step 1 and producing the aluminum substrate 3 having through-holes (Figs. 5 and 6).

In the example shown in Fig. 4, the aluminum hydroxide film 2 is formed on both sides of the aluminum substrate 1 in the film forming step, but the present invention is not limited thereto. The aluminum hydroxide film 2 may be formed only on one side of the aluminum substrate 1.

[Film forming step]

In the present invention, the film forming step included in the method for producing an electromagnetic wave shielding member is a step of subjecting the surface of the aluminum substrate to a film forming treatment to form an aluminum hydroxide film.

[Film forming treatment]

The film forming treatment is not particularly limited and for example, the same treatment as the conventionally known aluminum hydroxide film forming treatment can be carried out.

For example, the conditions and apparatus described in paragraphs [0013] to [0026] of JP2011-201123A can be appropriately adopted for the film forming treatment.

In the present invention, the conditions for the film forming treatment vary depending on the electrolytic solution used and therefore cannot be determined indiscriminately. In general, the conditions for the film forming treatment are appropriately an electrolytic solution concentration of 1% to 80% by mass, a liquid temperature of 5°C to 70°C, a current density of 0.5 to 60 A/dm$^2$, a voltage of 1 to 100 V, and an electrolysis time of 1 second to 20 minutes and are adjusted to obtain a desired coating amount.

In the present invention, it is preferable to carry out an electrochemical treatment using nitric acid, hydrochloric acid, sulfuric acid, phosphoric acid or oxalic acid, or a mixed acid of two or more of these acids as the electrolytic solution.

In a case where the electrochemical treatment is carried out in an electrolytic solution containing nitric acid or hydrochloric acid, a direct current may be applied between the aluminum substrate and the counter electrode, or an alternating current may be applied therebetween. In a case where a direct current is applied to the aluminum substrate, the current density is preferably 1 to 60 A/dm$^2$ and more preferably 5 to 50 A/dm$^2$. In a case where an electrochemical treatment is continuously carried out, it is preferable to carry out the electrochemical treatment by a liquid power feeding method in which power is fed to an aluminum substrate through an electrolytic solution.

In the present invention, the amount of the aluminum hydroxide film formed by the film forming treatment is preferably 0.05 to 50 g/m$^2$ and more preferably 0.1 to 10 g/m$^2$.

[Through-hole forming step 1]

The through-hole forming step 1 is a step of carrying out an electrolytic dissolution treatment after the film forming step to form through-holes.

<Electrolytic dissolution treatment>

The electrolytic dissolution treatment is not particularly limited, and is carried out using a direct current or an alternating current, in which an acidic solution can be used as the electrolytic solution. Above all, the electrochemical treatment is preferably carried out using at least one of nitric acid or hydrochloric acid, and the electrochemical treatment is more preferably carried out using a mixed acid obtained by adding at least one or more acids of sulfuric acid, phosphoric

acid, and oxalic acid to these acids.

In the present invention, as the acidic solution which is an electrolytic solution, in addition to the above-mentioned acids, it is also possible to use the electrolytic solutions described in the specifications of US4671859A, US4661219A, US4618405A, US4600482A, US4566960A, US4566958A, US4566959A, US4416972A, US4374710A, US4336113A, and US4184932A.

The concentration of the acidic solution is preferably 0.1% to 2.5% by mass and particularly preferably 0.2% to 2.0% by mass. In addition, the liquid temperature of the acidic solution is preferably 20°C to 80°C and more preferably 30°C to 60°C.

Further, the aqueous solution mainly composed of an acid can be used by adding at least one of a nitrate compound having a nitrate ion such as aluminum nitrate, sodium nitrate and/or ammonium nitrate, a hydrochloric acid compound having a hydrochloric acid ion such as aluminum chloride, sodium chloride and/or ammonium chloride, or a sulfuric acid compound having a sulfate ion such as aluminum sulfate, sodium sulfate and/or ammonium sulfate in the range from 1 g/L to saturation to the aqueous solution of acid having a concentration of 1 to 100 g/L.

Here, the phrase "mainly composed of" means that the component which becomes the main component in the aqueous solution is contained in an amount of 30% by mass or more and preferably 50% by mass or more, with respect to the entire components added to the aqueous solution. Hereinafter, the same applies to the other components.

Moreover, the metal contained in an aluminum alloy, such as iron, copper, manganese, nickel, titanium, magnesium and/or silica, may be dissolved in the aqueous solution mainly composed of an acid. Preferably, it is preferable to use a solution obtained by adding aluminum chloride, aluminum nitrate, and/or aluminum sulfate or the like to an aqueous solution with an acid concentration of 0.1% to 2% by mass so that aluminum ion is 1 to 100 g/L.

A direct current is mainly used for the electrochemical dissolution treatment, but in a case where an alternating current is used, the alternating current power wave is not particularly limited, and a sine wave, a rectangular wave, a trapezoidal wave, and/or a triangular wave is used. Among them, a rectangular wave or a trapezoidal wave is preferable, and a trapezoidal wave is particularly preferable.

(Nitric acid electrolysis)

In the present invention, through-holes having an average opening diameter of 1 μm or more and 100 μm or less can be easily formed by an electrochemical dissolution treatment using an electrolytic solution mainly composed of nitric acid (hereinafter, also simply referred to as "nitric acid dissolution treatment").

Here, the nitric acid dissolution treatment is preferably an electrolytic treatment carried out under the conditions that a direct current is used, the average current density is 5 $A/dm^2$ or more, and the electric quantity is 50 $C/dm^2$ or more because it is easy to control the dissolution point of through-hole formation. In addition, the average current density is preferably 100 $A/dm^2$ or less, and the electric quantity is preferably 10000 $C/dm^2$ or less.

Further, the concentration and temperature of the electrolytic solution in nitric acid electrolysis are not particularly limited. Electrolysis can be carried out at 30°C to 60°C using a nitric acid electrolytic solution having a high nitric acid concentration, for example, a nitric acid concentration of 15% to 35% by mass, or electrolysis can be carried out at a high temperature, for example, 80°C or higher, using a nitric acid electrolytic solution having a nitric acid concentration of 0.7% to 2% by mass.

In addition, electrolysis can be carried out using an electrolytic solution prepared by mixing at least one of sulfuric acid, oxalic acid, or phosphoric acid at a concentration of 0.1% to 50% by mass with the above nitric acid electrolytic solution.

(Hydrochloric acid electrolysis)

In the present invention, through-holes having an average opening diameter of 1 μm or more and 100 μm or less can be easily formed by an electrochemical dissolution treatment using an electrolytic solution mainly composed of hydrochloric acid (hereinafter, also simply referred to as "hydrochloric acid dissolution treatment").

Here, the hydrochloric acid dissolution treatment is preferably an electrolytic treatment carried out under the conditions that a direct current is used, the average current density is 5 $A/dm^2$ or more, and the electric quantity is 50 $C/dm^2$ or more because it is easy to control the dissolution point of through-hole formation. In addition, the average current density is preferably 100 $A/dm^2$ or less, and the electric quantity is preferably 10000 $C/dm^2$ or less.

Further, the concentration and temperature of the electrolytic solution in hydrochloric acid electrolysis are not particularly limited. Electrolysis can be carried out at 30°C to 60°C using a hydrochloric acid electrolytic solution having a high hydrochloric acid concentration, for example, a hydrochloric acid concentration of 10% to 35% by mass, or electrolysis can be carried out at a high temperature, for example, 80°C or higher, using a hydrochloric acid electrolytic solution having a hydrochloric acid concentration of 0.7% to 2% by mass.

In addition, electrolysis can be carried out using an electrolytic solution prepared by mixing at least one of

sulfuric acid, oxalic acid, or phosphoric acid at a concentration of 0.1% to 50% by mass with the above hydrochloric acid electrolytic solution.

[Film removal step]

The film removing step is a step of carrying out a chemical dissolution treatment to remove an aluminum hydroxide film.
In the film removing step, the aluminum hydroxide film can be removed, for example, by carrying out an acid etching treatment and/or an alkali etching treatment which will be described later.

<Acid etching treatment>

The dissolution treatment is a treatment in which an aluminum hydroxide film is dissolved using a solution in which aluminum hydroxide is dissolved preferentially to aluminum (hereinafter, referred to as "aluminum hydroxide liquid solution").
Here, the aluminum hydroxide liquid solution is preferably an aqueous solution containing at least one selected from the group consisting of, for example, nitric acid, hydrochloric acid, sulfuric acid, phosphoric acid, oxalic acid, a chromium compound, a zirconium-based compound, a titanium-based compound, a lithium salt, a cerium salt, a magnesium salt, a sodium silicofluoride, a zinc fluoride, a manganese compound, a molybdenum compound, a magnesium compound, a barium compound, and a halogen simple substance.
Specifically, examples of the chromium compound include chromium (III) oxide and chromium (VI) anhydride.
Examples of the zirconium-based compound include ammonium zirconium fluoride, zirconium fluoride, and zirconium chloride.
Examples of the titanium-based compound include titanium oxide and titanium sulfide.
Examples of the lithium salt include lithium fluoride and lithium chloride.
Examples of the cerium salt include cerium fluoride and cerium chloride.
Examples of the magnesium salt include magnesium sulfide.
Examples of the manganese compound include sodium permanganate and calcium permanganate.
Examples of the molybdenum compound include sodium molybdate.
Examples of the magnesium compound include magnesium fluoride pentahydrate.
Examples of the barium compound include barium oxide, barium acetate, barium carbonate, barium chlorate, barium chloride, barium fluoride, barium iodide, barium lactate, barium oxalate, barium perchlorate, barium selenate, barium selenite, barium stearate, barium sulfite, barium titanate, barium hydroxide, barium nitrate, and hydrates thereof.
Among the above-mentioned barium compounds, barium oxide, barium acetate, and barium carbonate are preferable, and barium oxide is particularly preferable.
Examples of the halogen simple substance include chlorine, fluorine, and bromine.
Among them, the aluminum hydroxide liquid solution is preferably an aqueous solution containing an acid, and examples of the acid include nitric acid, hydrochloric acid, sulfuric acid, phosphoric acid, oxalic acid, and a mixture of two or more acids. Above all, it is preferable to use nitric acid as the acid.
The acid concentration is preferably 0.01 mol/L or more, more preferably 0.05 mol/L or more, and still more preferably 0.1 mol/L or more. The upper limit of the acid concentration is not particularly limited, but is generally preferably 10 mol/L or less and more preferably 5 mol/L or less.
The dissolution treatment is carried out by bringing the aluminum substrate on which an aluminum hydroxide film is formed into contact with the above-mentioned liquid solution. The method for contacting is not particularly limited, and examples thereof include a dipping method and a spraying method, among which a dipping method is preferable.
The dipping method is a treatment of dipping the aluminum substrate on which an aluminum hydroxide film is formed in the above-mentioned liquid solution. Stirring during the dipping treatment is preferable because the treatment without unevenness is carried out.
The dipping treatment time is preferably 10 minutes or more, more preferably 1 hour or more, still more preferably 3 hours or more, and even more preferably 5 hours or more.

<Alkali etching treatment>

The alkali etching treatment is a treatment in which the surface layer is dissolved by bringing the aluminum hydroxide film into contact with an alkaline solution.
Examples of the alkali used for the alkaline solution include caustic alkali and alkali metal salts. Specific examples of the caustic alkali include sodium hydroxide (caustic soda) and caustic potash. In addition, examples of the alkali metal salt include alkali metal silicates such as sodium metasilicate, sodium silicate, potassium metasilicate, and potassium

silicate; alkali metal carbonates such as sodium carbonate and potassium carbonate; alkali metal aluminates such as sodium aluminate and potassium aluminate; alkali metal aldonates such as sodium gluconate and potassium gluconate; and alkali metal hydrogen phosphates such as sodium diphosphate, potassium diphosphate, sodium triphosphate, and potassium triphosphate. Among them, a solution of caustic alkali and a solution containing both caustic alkali and alkali metal aluminate are preferable from the viewpoint of high etching rate and low cost. In particular, an aqueous solution of sodium hydroxide is preferable.

The concentration of the alkaline solution is preferably 0.1% to 50% by mass and more preferably 0.2% to 10% by mass. In a case where aluminum ions are dissolved in the alkaline solution, the concentration of the aluminum ions is preferably 0.01% to 10% by mass and more preferably 0.1% to 3% by mass. The temperature of the alkaline solution is preferably 10°C to 90°C. The treatment time is preferably 1 to 120 seconds.

Examples of the method of bringing an aluminum hydroxide film into contact with an alkaline solution include a method of passing an aluminum substrate on which an aluminum hydroxide film is formed through a tank containing an alkaline solution; a method of dipping an aluminum substrate on which an aluminum hydroxide film is formed in a bath containing an alkaline solution; and a method of spraying an alkaline solution onto the surface (aluminum hydroxide film) of an aluminum substrate on which an aluminum hydroxide film is formed.

In addition, the production method in a case of using a metal other than aluminum as the material of the metal foil may be, for example, a production method including a resin layer forming step, a through-hole forming step 2, and a resin layer removing step shown below (hereinafter, also referred to as second production method). The second production method can be applied also in a case where aluminum is used as the material of the metal foil.

The resin layer forming step is a step of forming a resin layer in which a part of each of metal particles is embedded in one main surface of the metal foil using a composition containing a plurality of metal particles and a polymer component.

The through-hole forming step 2 is a step of bringing the metal foil having a resin layer into contact with an etchant after the resin layer forming step to dissolve metal particles and a part of the metal foil to form through-holes in the metal foil.

The resin layer removing step is a step of removing the resin layer after the through-hole forming step 2 to produce an electromagnetic wave shielding member having through-holes.

The second production method preferably includes, before the through-hole forming step 2, a protective layer forming step of forming a protective layer on the main surface of the metal foil opposite to the surface on which the resin layer is formed, using a composition containing a polymer component.

In the second production method, after passing through the resin layer forming step, the through-hole forming step 2 of dissolving the metal particles and a part of the metal foil to form through-holes is carried out, and thereafter the resin layer is removed, whereby a metal foil having a plurality of fine through-holes can be easily produced.

Next, an outline of each step in the second production method will be described with reference to Figs. 7 to 10, and then each treatment step included in the second production method will be described in detail.

In the second production method, as shown in Fig. 7, a resin layer 14 in which a portion of each of a plurality of metal particles 16 is embedded is formed on one main surface of the metal foil 12, by the resin layer forming step using a composition containing a plurality of metal particles and a polymer component.

In the second production method, as shown in Fig. 8, it is preferable to form a protective layer 18 on the main surface of the metal foil 12 opposite to the surface on which the resin layer 14 is formed, by an optional protective layer forming step using a composition containing a polymer component.

In the second production method, as shown in Fig. 9, through-holes 5 are formed in the resin layer 14 and the metal foil 12, by the through-hole forming step 2 of bringing the metal foil having a resin layer into contact with an etchant to dissolve the metal particles and a part of the metal foil.

In the second production method, as shown in Fig. 10, an electromagnetic wave shielding member 10 comprising the metal foil 3 having a plurality of through-holes 5 is formed by the resin layer removing step of removing a resin layer. In addition, in a case where the second production method includes a protective layer forming step, as shown in Fig. 10, the resin layer and the protective layer are removed by the resin layer removing step, whereby the electromagnetic wave shielding member 10 having a plurality of through-holes 5 is formed.

[Resin layer forming step]

The resin layer forming step of the second production method is a step of forming a resin layer in which a part of each of metal particles is embedded in one main surface of the metal foil using a composition containing a plurality of metal particles and a polymer component.

[Composition]

The composition used in the resin layer forming step is a composition containing at least a plurality of metal particles and a polymer component.

<Metal particle>

The metal particle contained in the foregoing composition is not particularly limited as long as it is a particle containing a metal atom that dissolves in the etchant used in the through-hole forming step 2 which will be described later, but it is preferably a particle composed of a metal and/or a metal compound, and more preferably a particle composed of a metal.

Specific examples of the metal constituting the metal particles include aluminum, nickel, iron, copper, stainless steel, titanium, tantalum, molybdenum, niobium, zirconium, tungsten, beryllium, and alloys thereof. These metals may be used alone or in combination of two or more thereof.

Among these, aluminum, nickel, and copper are preferable, and aluminum and copper are more preferable.

Examples of the metal compound constituting the metal particles include oxides, composite oxides, hydroxides, carbonates, sulfates, silicates, phosphates, nitrides, carbides, sulfides, and composites of at least two or more thereof. Specific examples thereof include copper oxide, aluminum oxide, aluminum nitride, and aluminum borate.

In the second production method, the metal particles and the above-mentioned metal foil preferably contain the same metal atom from the viewpoint of recovering the etchant used in the through-hole removing step which will be described later and recycling the dissolved metal.

The shape of the metal particles is not particularly limited, but is preferably spherical and more preferably closer to a true spherical shape.

In addition, the average particle size of the metal particles is preferably 1 $\mu$m to 10 $\mu$m and more preferably more than 2 $\mu$m and 6 $\mu$m or less, from the viewpoint of dispersibility in the composition and the like.

Here, the average particle size of the metal particles refers to a 50% cumulative diameter of the particle size distribution measured by a laser diffraction/scattering particle size analyzer (MICROTRAC MT3000 manufactured by Nikkiso Co., Ltd.).

In addition, the content of the metal particles is preferably 0.05% to 95% by mass, more preferably 1% to 50% by mass, and still more preferably 3% to 25% by mass with respect to the total solid content contained in the composition.

<Polymer component>

The polymer component contained in the composition is not particularly limited, and a conventionally known polymer component can be used.

Specific examples of the polymer component include an epoxy-based resin, a silicone-based resin, an acrylic resin, a urethane-based resin, an ester-based resin, a urethane acrylate-based resin, a silicone acrylate-based resin, an epoxy acrylate-based resin, an ester acrylate-based resin, a polyamide-based resin, a polyimide-based resin, a polycarbonate-based resin, and a phenol-based resin. These resins may be used alone or in combination of two or more thereof.

Among them, the polymer component is preferably a resin material selected from the group consisting of a phenol-based resin, an acrylic resin, and a polyimide-based resin, from the viewpoint of exhibiting excellent acid resistance and easily obtaining the desired through-holes even in a case where an acid solution is used as the etchant used in the through-hole forming step 2 which will be described later.

In the present invention, from the viewpoint of facilitating removal in the resin layer removing step which will be described later, the polymer component contained in the composition is preferably a water-insoluble and alkaline water-soluble polymer (hereinafter, simply referred to as "alkaline water-soluble polymer"), that is, a homopolymer which contains an acidic group in the main chain or side chain of the polymer, a copolymer thereof, or a mixture thereof.

As the alkaline water-soluble polymer, one having an acidic group in the main chain and/or side chain of the polymer is preferable from the viewpoint of further facilitating the removal in the resin layer removing step which will be described later.

Specific examples of the acidic group include a phenol group (-Ar-OH), a sulfonamide group ($-SO_2NH-R$), a substituted sulfonamide-based acid group (hereinafter, referred to as "active imide group") [$-SO_2NHCOR$, $-SO_2NHSO_2R$, $-CONHSO_2R$], a carboxyl group ($-CO_2H$), a sulfo group ($-SO_3H$), and a phosphonic group ($-OPO_3H_2$).

Ar represents a divalent aryl linking group which may have a substituent, and R represents a hydrocarbon group which may have a substituent.

Among the above-mentioned alkaline water-soluble polymers having an acidic group, an alkaline water-soluble polymer having a phenol group, a carboxyl group, a sulfonamide group, or an active imide group is preferable, and

particularly an alkaline water-soluble polymer having a phenol group or a carboxyl group is most preferable from the viewpoint of the balance of the strength of the resin layer to be formed and the removability in the resin layer removing step which will be described later.

Examples of the alkaline water-soluble polymer having an acidic group include the following.

Examples of alkaline water-soluble polymers having a phenol group include novolak resins produced from one or more of phenols such as phenol, o-cresol, m-cresol, p-cresol, and xylenol, and aldehydes such as formaldehyde and paraformaldehyde, and polycondensates of pyrogallol and acetone. Further, a copolymer obtained by copolymerizing a compound having a phenol group can also be mentioned. Examples of the compound having a phenol group include acrylamide, methacrylamide, acrylic acid ester, methacrylic acid ester, and hydroxystyrene, each of which has a phenol group.

Specific examples of the compound having a phenol group include N-(2-hydroxyphenyl)acrylamide, N-(3-hydroxyphenyl)acrylamide, N-(4-hydroxyphenyl)acrylamide, N-(2-hydroxyphenyl)methacrylamide, N-(3-hydroxyphenyl)methacrylamide, N-(4-hydroxyphenyl)methacrylamide, o-hydroxyphenyl acrylate, m-hydroxyphenyl acrylate, p-hydroxyphenyl acrylate, o-hydroxyphenyl methacrylate, m-hydroxyphenyl methacrylate, p-hydroxyphenyl methacrylate, o-hydroxystyrene, m-hydroxystyrene, p-hydroxystyrene, 2-(2-hydroxyphenyl)ethyl acrylate, 2-(3-hydroxyphenyl)ethyl acrylate, 2-(4-hydroxyphenyl)ethyl acrylate, 2-(2-hydroxyphenyl)ethyl methacrylate, 2-(3-hydroxyphenyl)ethyl methacrylate, and 2-(4-hydroxyphenyl)ethyl methacrylate.

Above all, novolak resins or hydroxystyrene copolymers are preferable. Commercially available products of hydroxystyrene copolymers are, Maruka Linker MH-2, Maruka Linker M S-4, Maruka Linker M S-2, and Maruka Linker M S-1 (all of which are manufactured by Maruzen Petrochemical Co., Ltd.), and VP-8000 and VP-15000 (both of which are manufactured by Nippon Soda Co., Ltd.).

Examples of the alkaline water-soluble polymer having a sulfonamide group include a polymer composed of a minimum constitutional unit derived from a compound having a sulfonamide group as a main constitutional component. Examples of such a compound include compounds having one or more sulfonamide groups in which at least one hydrogen atom is bonded to a nitrogen atom, and one or more polymerizable unsaturated groups in the molecule thereof. Above all, a low molecular weight compound having an acryloyl group, an allyl group, or a vinyloxy group and a substituted or monosubstituted aminosulfonyl group or a substituted sulfonylimino group in the molecule thereof is preferable.

In particular, m-aminosulfonylphenyl methacrylate, N-(p-aminosulfonylphenyl)methacrylamide, and/or N-(p-aminosulfonylphenyl)acrylamide, and the like can be suitably used.

Examples of the alkaline water-soluble polymer having an active imide group include polymers composed of a minimum constitutional unit derived from a compound having an active imide group as a main constitutional component. Examples of such a compound include compounds having one or more active imide groups represented by the following structural formula and one or more polymerizable unsaturated groups in the molecule thereof.

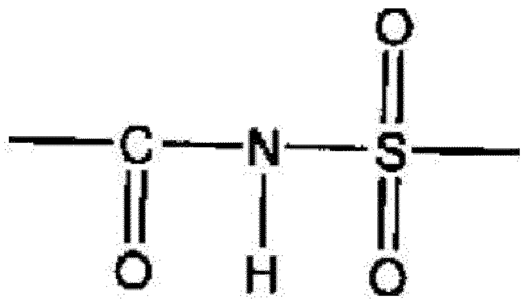

Specifically, N-(p-toluenesulfonyl)methacrylamide, N-(p-toluenesulfonyl)acrylamide, and the like can be suitably used.

Examples of the alkaline water-soluble polymer having a carboxyl group include polymers having a minimum constitutional unit derived from a compound having one or more carboxyl groups and one or more polymerizable unsaturated groups in the molecule thereof as a main constitutional component. Specific examples of the alkaline water-soluble polymer having a carboxyl group include polymers using unsaturated carboxylic acid compounds such as acrylic acid, methacrylic acid, maleic acid anhydride, and itaconic acid.

Examples of the alkaline water-soluble polymer having a sulfo group include polymers having a minimum constitutional unit derived from a compound having one or more sulfo groups and one or more polymerizable unsaturated groups in the molecule thereof as a main constitutional unit.

Examples of the alkaline water-soluble polymer having a phosphonic group include polymers having a minimum constitutional unit derived from a compound having one or more phosphonic groups and one or more polymerizable unsaturated groups in the molecule thereof as a main constitutional component.

The minimum constitutional unit having an acidic group, which constitutes the alkaline water-soluble polymer, does not have to be particularly limited to one type, and it is also possible to use one obtained by copolymerizing two or more types of minimum constitutional units having the same acidic group, or two or more types of minimum constitutional units having different acidic groups.

As a method of copolymerization, a graft copolymerization method, a block copolymerization method, and/or a random copolymerization method which is conventionally known can be used.

The content of the compound having an acidic group to be copolymerized in the copolymer is preferably 10 mol% or more and more preferably 20 mol% or more.

In the present invention, in a case where the compound is copolymerized to form a copolymer, other compounds containing no acidic group can also be used as the compound. Examples of other compounds containing no acidic group include the compounds listed in the following (m1) to (m11).

(m1) acrylic acid esters having an aliphatic hydroxyl group and methacrylic acid esters having an aliphatic hydroxyl group such as 2-hydroxyethyl acrylate or 2-hydroxyethyl methacrylate.
(m2) alkyl acrylates such as methyl acrylate, ethyl acrylate, propyl acrylate, butyl acrylate, amyl acrylate, hexyl acrylate, octyl acrylate, benzyl acrylate, 2-chloroethyl acrylate, glycidyl acrylate, and N-dimethylaminoethyl acrylate.
(m3) alkyl methacrylates such as methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate, glycidyl methacrylate, and N-dimethylamino ethyl methacrylate.
(m4) acrylamides or methacrylamides such as acrylamide, methacrylamide, N-methylol acrylamide, N-ethyl acrylamide, N-hexyl methacrylamide, N-cyclohexyl acrylamide, N-hydroxyethyl acrylamide, N-phenyl acrylamide, N-nitrophenyl acrylamide, and N-ethyl-N-phenyl acrylamide.
(m5) vinyl ethers such as ethyl vinyl ether, 2-chloroethyl vinyl ether, hydroxyethyl vinyl ether, propyl vinyl ether, butyl vinyl ether, octyl vinyl ether, and phenyl vinyl ether.
(m6) Vinyl acetates such as vinyl acetate, vinyl chloroacetate, vinyl butyrate, and vinyl benzoate.
(m7) styrenes such as styrene, $\alpha$-methylstyrene, methylstyrene, and chloromethylstyrene.
(m8) vinyl ketones such as methyl vinyl ketone, ethyl vinyl ketone, propyl vinyl ketone, and phenyl vinyl ketone.
(m9) olefins such as ethylene, propylene, isobutylene, butadiene, and isoprene.
(m10) N-vinylpyrrolidone, N-vinylcarbazole, 4-vinylpyridine, acrylonitrile, methacrylonitrile, and the like.
(m11) unsaturated imides such as maleimide, N-acryloyl acrylamide, N-acetyl methacrylamide, N-propionyl methacrylamide, and N-(p-chlorobenzoyl)methacrylamide.

Regardless of homopolymer or copolymer, the polymer component preferably has a weight-average molecular weight of $1.0\times10^3$ to $2.0\times10^5$ and a number-average molecular weight of $5.0\times10^2$ to $1.0\times10^5$. Further, the polymer component preferably has a polydispersity (weight-average molecular weight/number-average molecular weight) of 1.1 to 10.

In a case where a copolymer is used as the polymer component, the blending weight ratio of the minimum constitutional unit derived from the compound having an acidic group, which constitutes the main chain and/or the side chain, and the other minimum constitutional unit containing no acidic group, which constitutes a part of the main chain and/or the side chain, is preferably in the range of 50:50 to 5:95 and more preferably in the range of 40:60 to 10:90.

Only one type of each of the foregoing polymer components may be used, or two or more types thereof may be used in combination. The polymer component is used preferably in the range of 30% to 99% by mass, more preferably in the range of 40% to 95% by mass, and still more preferably in the range of 50% to 90% by mass with respect to the total solid content contained in the composition.

In the second production method, with respect to the metal particles and the polymer component described above, it is preferred that the specific gravity of the metal particles is larger than the specific gravity of the polymer component because the formation of through-holes is easy in the through-hole forming step 2 which will be described later. Specifically, it is more preferred that the specific gravity of the metal particles is 1.5 or more, and the specific gravity of the polymer component is 0.9 or more and less than 1.5.

<Surfactant>

From the viewpoint of coatability, a nonionic surfactant as described in JP1987-251740A (JP-S62-251740A) and/or JP1991-208514A (JP-H03-208514A), or an amphoteric surfactant as described in JP1984-121044A (JP-S59-121044A) and/or JP1992-013149A(JP-H04-013149A) can be added to the composition described above.

Specific examples of the nonionic surfactant include sorbitan tristearate, sorbitan monopalmitate, sorbitan trioleate, stearic acid monoglyceride, and polyoxyethylene nonyl phenyl ether.

Specific examples of amphoteric surfactant include alkyl di(aminoethyl)glycine, alkyl polyaminoethylglycine

hydrochloride, 2-alkyl-N-carboxyethyl-N-hydroxyethylimidazolinium betaine, and N-tetradecyl-N,N-betaine type (for example, trade name AMOGEN K, manufactured by DKS Co., Ltd.).

The surfactant content in a case of containing the surfactant is preferably 0.01% to 10% by mass and more preferably 0.05% to 5% by mass, with respect to the total solid content contained in the composition.

<Solvent>

A solvent can be added to the composition from the viewpoint of workability in a case of forming a resin layer.

Specific examples of the solvent include ethylene dichloride, cyclohexanone, methyl ethyl ketone, methanol, ethanol, propanol, ethylene glycol mono methyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene, and water. These solvent compounds may be used alone or in combination of two or more thereof.

<Forming method>

Although the method of forming a resin layer using the composition described above is not particularly limited, a method of applying a composition on a metal foil to form a resin layer is preferable.

The method of applying on the metal foil is not particularly limited. For example, methods such as a bar coating method, a slit coating method, an ink jet method, a spraying method, a roll coating method, a spin coating method, a cast coating method, a slit and spin method, and a transfer method can be used.

In the present invention, it is preferable to form the resin layer so as to satisfy Formula (1) because the formation of through-holes is easy in the through-hole forming step 2 which will be described later.

$$n<r\cdots(1)$$

In Formula (1), n represents the thickness of the resin layer to be formed, r represents the average particle size of the metal particles contained in the composition, and the units of n and r both represent μm.

Further, in the second production method, the thickness of the resin layer formed by the resin layer forming step is preferably 0.5 to 4 μm and more preferably 1 μm or more and 2 μm or less from the viewpoint of the resistance to the etchant used in the through-hole forming step 2 which will be described later, the workability in the resin layer removing step which will be described later, or the like.

Here, the average thickness of the resin layer refers to an average value of the thickness of any five points measured in a case where the resin layer is cut using a microtome and the cross section of the cut resin layer is observed with an electron microscope.

[Protective layer forming step]

Further, from the viewpoint of workability in the through-hole forming step 2 which will be described later, the second production method preferably includes, before the through-hole forming step 2, a protective layer forming step of forming a protective layer on the main surface of the metal foil opposite to the surface on which the resin layer is formed, using a composition containing a polymer component.

Here, the polymer component may be the same as the polymer component contained in the composition used in the above-mentioned resin layer forming step. That is, the protective layer formed in the optional protective layer forming step is the same layer as the above-mentioned resin layer, except that the above-mentioned metal particles are not embedded. Also about the method of forming a protective layer, the protective layer can be formed by the same method as the above-mentioned resin layer, except that the above-mentioned metal particles are not used.

In addition, in a case where the protective layer forming step is included and then in a case where the protective layer forming step is a step before the through-hole forming step 2, the order of the steps is not particularly limited, and the protective layer forming step may be carried out before, after, or simultaneously with the above-mentioned resin layer forming step.

[Through-hole forming step 2]

The through-hole forming step 2 included in the second production method is a step of bringing a metal foil having a resin layer into contact with an etchant to dissolve metal particles and a part of the metal foil to form through-holes in the metal foil, after the above-mentioned resin layer forming step, and is a step of forming through-holes in the metal foil by so-called chemical etching.

[Etchant]

It is possible to appropriately use a chemical solution of acid or alkali or the like as the etchant, in a case where it is an etchant suitable for the metal species of the metal particles and the metal foil.
Examples of the acid include hydrochloric acid, sulfuric acid, nitric acid, hydrofluoric acid, hydrogen peroxide, and acetic acid.
Examples of the alkali include caustic soda and caustic potash.
Examples of the alkali metal salt include alkali metal silicates such as sodium metasilicate, sodium silicate, potassium metasilicate, and potassium silicate; alkali metal carbonates such as sodium carbonate and potassium carbonate; alkali metal aluminates such as sodium aluminate and potassium aluminate; alkali metal aldonates such as sodium gluconate and potassium gluconate; and alkali metal hydrogen phosphates such as sodium diphosphate, potassium diphosphate, sodium triphosphate, and potassium triphosphate.
In addition, inorganic salts such as iron (III) chloride and copper (II) chloride can also be used.
In addition, these compounds may be used alone or in combination of two or more thereof.

[Treatment method]

The treatment of forming through-holes is carried out by bringing a metal foil having a resin layer into contact with the above-mentioned etchant.
The method of bringing the metal foil into contact with the etchant is not particularly limited, and examples thereof include a dipping method and a spraying method, among which a dipping method is preferable.
The dipping treatment time is preferably 15 seconds to 10 minutes and more preferably 1 minute to 6 minutes.
In addition, the liquid temperature of the etchant at the time of dipping is preferably 25°C to 70°C and more preferably 30°C to 60°C.

[Resin layer removing step]

The resin layer removing step included in the production method of the present invention is a step of removing the resin layer to produce an electromagnetic wave shielding member having through-holes, after the above-mentioned through-hole forming step 2.
The method of removing the resin layer is not particularly limited, but in a case of using the above-mentioned alkaline water-soluble polymer as the polymer component, a method of dissolving and removing the resin layer using an alkaline aqueous solution is preferable.

[Alkaline aqueous solution]

Specific examples of the alkaline aqueous solution include inorganic alkalis such as sodium hydroxide, potassium hydroxide, sodium carbonate, sodium silicate, sodium metasilicate, and aqueous ammonia; primary amines such as ethylamine and n-propylamine; secondary amines such as diethylamine and di-n-butylamine; tertiary amines such as triethylamine and methyl diethylamine; alcohol amines such as dimethylethanolamine and triethanolamine; quaternary ammonium salts such as tetramethyl ammonium hydroxide and tetraethylammonium hydroxide; and cyclic amines such as pyrrole and piperidine. These compounds may be used alone or in combination of two or more thereof.
Further, appropriate amounts of an alcohol and a surfactant can be added to the alkaline aqueous solution.

[Treatment method]

The treatment of removing a resin layer is carried out, for example, by bringing the metal foil having a resin layer after the through-hole forming step 2 into contact with the above-mentioned alkaline aqueous solution.
The method of bringing the metal foil into contact with the alkaline aqueous solution is not particularly limited, and examples thereof include a dipping method and a spraying method, among which a dipping method is preferable.
The dipping time is preferably 5 seconds to 5 minutes and more preferably 10 seconds to 2 minutes.
Further, the temperature of the alkaline aqueous solution at the time of dipping is preferably 25°C to 60°C and more preferably 30°C to 50°C.

[Anticorro sion treatment]

The second production method preferably includes a step of carrying out an anticorrosion treatment.
In addition, the timing of carrying out the anticorrosion treatment is not particularly limited. The anticorrosion treatment may be, for example, a treatment applied to the metal foil used in the resin layer forming step, a treatment of adding a triazole or the like described later to the alkaline aqueous solution in the resin layer removing step, or a treatment applied after the resin layer removing step.
The anticorrosion treatment may be, for example, a treatment of dipping a metal foil in a solution having a pH of 5 to 8.5 in which at least a triazole is dissolved in a solvent to form an organic dielectric film.
Suitable examples of triazoles include benzotriazole (BTA) and tolyltriazole (TTA).
In addition to triazoles, various organic anticorrosives, thiazoles, imidazoles, mercaptans, and/or triethanolamine can also be used.
Water or an organic solvent (especially alcohol) can be suitably used as the solvent used for the anticorrosion treatment, but the solvent is preferably water mainly composed of deionized water, in view of the uniformity of the organic dielectric film to be formed, easy control of the thickness at the time of mass production, convenience, further the influence on the environment, and the like.
The dissolution concentration of the triazoles can be appropriately determined depending on the thickness of the organic dielectric film to be formed and the treatment time, but it may be usually about 0.005% to 1% by weight.
In addition, the temperature of the solution may be room temperature, but the solution may be heated and used if necessary.
The dipping time of the metal foil in the solution can be appropriately determined depending on the dissolution concentration of the triazoles and the thickness of the organic dielectric film to be formed, but it may be usually about 0.5 to 30 seconds.
As another specific example of the anticorrosion treatment, there is a method of forming an inorganic dielectric film mainly composed of hydrated oxide of chromium by dipping the metal foil in an aqueous solution formed by dissolving at least one selected from the group of chromium trioxide, chromate, and dichromate in water.
Here, the chromate is suitably, for example, potassium chromate or sodium chromate and the dichromate is suitably, for example, potassium dichromate or sodium dichromate. The dissolution concentration is usually set to 0.1% to 10% by mass, and the liquid temperature may be about room temperature to 60°C. The pH value of the aqueous solution is not particularly limited from the acidic region to the alkaline region, but is usually set to 1 to 12.
In addition, the dipping time of the metal foil is suitably selected depending on the thickness of the inorganic dielectric film to be formed, or the like.
In the present invention, it is preferable to carry out washing with water after completion of the above-mentioned treatment steps. Pure water, well water, and/or tap water can be used for washing with water. A nip device may be used to prevent the treatment liquid from being carried into the next step.

[Roll-to-roll treatment]

In the present invention, the treatment of each step may be carried out in a so-called sheet-fed manner using a cut sheet-like metal foil, or a treatment of so-called roll to roll (hereinafter, also referred to as "RtoR") may be carried out in which a long metal foil is subjected to a treatment of each step while being transported in a longitudinal direction along a predetermined transport path.
In the present invention, RtoR is a production method which continuously carries out treatments of the resin layer forming step, the through-hole forming step, and the like described above one by one by individual treatment devices disposed on the transport path while delivering the metal foil from a roll formed by winding a long metal foil and transporting it in the longitudinal direction, and winds the treated metal foil (that is, electromagnetic wave shielding member) again in roll shape.

Examples

Hereinafter, the present invention will be described in more detail with reference to Examples. The materials, amounts used, proportions, treatment contents, treatment procedures, and the like shown in the following Examples can be appropriately changed without departing from the spirit of the present invention. Accordingly, the scope of the present invention should not be construed as being limited by the following Examples.

[Example 1]

<Preparation of electromagnetic wave shielding member>

The surface of an aluminum substrate (JIS H-4160, alloy number: 1085-H, aluminum purity: 99.85%) with an average thickness of 20 μm and a size of 200 mm × 300 mm is subjected to the treatment shown below to prepare an electromagnetic wave shielding member.

(a-1) Aluminum hydroxide film forming treatment (film forming step)

Using an electrolytic solution (nitric acid concentration: 1%, sulfuric acid concentration: 0.2%, aluminum concentration: 0.5%) kept at 50°C, the above aluminum substrate as a cathode was subjected to an electrolytic treatment to form an aluminum hydroxide film on the aluminum substrate. In addition, the electrolytic treatment was carried out by direct-current power supply. The electric current was applied at a current density of 40 $A/dm^2$ for 30 seconds.
The formation of the aluminum hydroxide film was followed by washing with water by spraying.

(b-1) Electrolytic dissolution treatment (through-hole forming step 1)

Next, using an electrolytic solution (nitric acid concentration: 1%, sulfuric acid concentration: 0.2%, aluminum concentration: 0.5%) kept at 50°C, the aluminum substrate as an anode was subjected to an electrolytic treatment under the condition of a total electric quantity of 780 $C/dm^2$ to form through-holes in the aluminum substrate and the aluminum hydroxide film. In addition, the electrolytic treatment was carried out by direct-current power supply. The current density was 25 $A/dm^2$.
The formation of the through-holes was followed by washing with water by spraying and then drying.

(c-1) Aluminum hydroxide film removing treatment (film removing step)

Then, the aluminum substrate after electrolytic dissolution treatment was dipped in an aqueous solution with a sodium hydroxide concentration of 5% by mass and an aluminum ion concentration of 0.5% by mass (liquid temperature: 35°C) for 30 seconds, and then in an aqueous solution with a sulfuric acid concentration of 30% and an aluminum ion concentration of 0.5% by mass (liquid temperature: 50°C) for 20 seconds to dissolve and remove the aluminum hydroxide film.
The removal of the aluminum film was followed by washing with water by spraying and then drying to prepare an electromagnetic wave shielding member having a plurality of through-holes.

[Example 2]

An electromagnetic wave shielding member was prepared in the same manner as in Example 1, except that an aluminum hydroxide film forming treatment shown in the following (a-2) was carried out in place of the aluminum hydroxide film forming treatment shown in the above (a-1), and the following (b-2) Electrolytic dissolution treatment (through-hole forming step 1) was carried out in place of the electrolytic dissolution treatment shown in the above (b-1).

(a-2) Aluminum hydroxide film forming treatment (film forming step)

Using an electrolytic solution (nitric acid concentration: 1%, sulfuric acid concentration: 0.2%, aluminum concentration: 0.5%) kept at 50°C, the above aluminum substrate as a cathode was subjected to an electrolytic treatment to form an aluminum hydroxide film on the aluminum substrate. In addition, the electrolytic treatment was carried out by direct-current power supply. The electric current was applied at a current density of 40 $A/dm^2$ for 40 seconds.
The formation of the aluminum hydroxide film was followed by washing with water by spraying.

(b-2) Electrolytic dissolution treatment (through-hole forming step 1)

Next, using an electrolytic solution (nitric acid concentration: 1%, sulfuric acid concentration: 0.2%, aluminum concentration: 0.5%) kept at 50°C, the aluminum substrate as an anode was subjected to an electrolytic treatment under the condition of a total electric quantity of 300 $C/dm^2$ to form through-holes in the aluminum substrate and the aluminum hydroxide film. In addition, the electrolytic treatment was carried out by direct-current power supply. The current density was 5 $A/dm^2$.
The formation of the through-holes was followed by washing with water by spraying and then drying.

[Example 3]

An electromagnetic wave shielding member was prepared in the same manner as in Example 1, except that the following (b-3) Electrolytic dissolution treatment (through-hole forming step 1) was carried out in place of the electrolytic dissolution treatment shown in the above (b-1).

(b-3) Electrolytic dissolution treatment (through-hole forming step 1)

Next, using an electrolytic solution (nitric acid concentration: 1%, sulfuric acid concentration: 0.2%, aluminum concentration: 0.5%) kept at 50°C, the aluminum substrate as an anode was subjected to an electrolytic treatment under the condition of a total electric quantity of 1000 C/dm$^2$ to form through-holes in the aluminum substrate and the aluminum hydroxide film. In addition, the electrolytic treatment was carried out by direct-current power supply. The current density was 22 A/dm$^2$.

The formation of the through-holes was followed by washing with water by spraying and then drying.

[Example 4]

Using an aluminum substrate (JIS H-4160, alloy number: 1085-H, aluminum purity: 99.85%) having an average thickness of 9.0 μm and a size of 200 mm × 300 mm as the metal foil, a 125 μm-thick PET was laminated as a resin layer on one surface of the aluminum substrate by the method disclosed in JP2013-121673A. Then, an electromagnetic wave shielding member was prepared in the same manner as in Example 1, except that an aluminum hydroxide film forming treatment shown in the following (a-3) was carried out in place of the aluminum hydroxide film forming treatment shown in the above (a-1), and the following (b-4) Electrolytic dissolution treatment (through-hole forming step 1) was carried out in place of the electrolytic dissolution treatment shown in the above (b-1).

(a-3) Aluminum hydroxide film forming treatment (film forming step)

Using an electrolytic solution (nitric acid concentration: 1%, sulfuric acid concentration: 0.2%, aluminum concentration: 0.5%) kept at 50°C, the above aluminum substrate as a cathode was subjected to an electrolytic treatment to form an aluminum hydroxide film on the aluminum substrate. In addition, the electrolytic treatment was carried out by direct-current power supply. The electric current was applied at a current density of 55 A/dm$^2$ for 10 seconds.

(b-4) Electrolytic dissolution treatment (through-hole forming step 1)

Next, using an electrolytic solution (nitric acid concentration: 1%, sulfuric acid concentration: 0.2%, aluminum concentration: 0.5%) kept at 50°C, the aluminum substrate as an anode was subjected to an electrolytic treatment under the condition of a total electric quantity of 400 C/dm$^2$ to form through-holes in the aluminum substrate and the aluminum hydroxide film. In addition, the electrolytic treatment was carried out by direct-current power supply. The current density was 35 A/dm$^2$.

The formation of the through-holes was followed by washing with water by spraying and then drying.

[Example 5]

<Preparation of electromagnetic wave shielding member>

A copper foil (JIS C 1100-H, electrolytic copper foil) having an average thickness of 10 μm and a size of 200 mm × 300 mm was used as the metal foil.

(d-1) Resin layer forming step

Composition 1 for forming a resin layer prepared to have the following composition was applied to one surface of a copper foil and then dried to form a resin layer A1 having a thickness of about 1 μm.

In addition, a composition prepared to have the same component ratio as the following composition 1 for forming a resin layer except that copper particles were removed was applied to the surface on the opposite side of the copper foil, and then dried to form a protective layer B1 having a thickness of about 1 μm.

| Composition 1 for forming resin layer | |
|---|---|
| • m,p-Cresolnovolak | 1.2 g |
| (m/p ratio = 6/4, weight-average molecular weight: 4100) | |
| • HXR-Cu | 0.4 g |
| (copper particles, average particle size: 5.0 μm, manufactured by Nippon Atomized Metal Powders Corporation) | |
| • MEGAFACE F-780-F | 0.1 g |
| (surfactant, manufactured by DIC Corporation) | |
| • Methyl ethyl ketone | 1.0 g |
| • 1-Methoxy-2-propanol | 5.0 g |

(e-1) Through-hole forming step 2

Then, the copper foil having the resin layer A1 and the protective layer B1 was dipped in an etchant (iron (III) chloride concentration: 30% by mass, hydrochloric acid concentration: 3.65% by mass) kept at 40°C for 3 minutes. This was followed by washing with water by spraying and then drying to form through-holes.

(f-1) Resin layer removing step

Then, the copper foil after formation of the through-holes was dipped in an alkaline aqueous solution (sodium hydroxide concentration: 0.4% by mass) at a liquid temperature of 50°C for 120 seconds to dissolve and remove the resin layer A1 and the protective layer B1.

This was followed by washing with water by spraying and then drying to prepare an electromagnetic wave shielding member having through-holes.

[Comparative Example 1]

An aluminum substrate was prepared according to the method disclosed in WO2008/078777A.

Specifically, with respect to an aluminum foil (thickness: 20 μm) in which crystal orientations were aligned, the temperature of the hydrochloric acid electrolytic solution and the electric quantity of the electrolytic treatment were adjusted to prepare an aluminum substrate having through-holes with an average opening diameter of 3 μm.

[Comparative Example 2]

An aluminum substrate was prepared according to the method disclosed in WO2008/078777A.

Specifically, a pattern was formed on the surface of a hard aluminum foil (thickness: 20 μm) by resist printing, followed by a chemical etching treatment with an alkaline treatment liquid to prepare an aluminum substrate having through-holes with an average opening diameter of 110 μm.

[Comparative Example 3]

An aluminum substrate was prepared according to the method disclosed in WO2008/078777A.

Specifically, through-holes (average opening diameter: 300 μm) were mechanically formed on a hard aluminum foil (thickness: 20 μm) with a punching die to prepare an aluminum substrate.

The thickness of the metal foil, the average opening diameter of the through-holes, and the average opening ratio in each of the electromagnetic wave shielding members prepared in Examples 1 to 5 and Comparative Examples 1 to 3 were measured by the above-mentioned method.

[Evaluation]

Shielding properties against electromagnetic waves of GHz band, transmittance with respect to electromagnetic waves from ultraviolet region to near-infrared region, and transmittance with respect to electromagnetic waves in middle infrared region in each of the electromagnetic wave shielding members prepared in Examples 1 to 5 and Comparative Examples 1 to 3 were evaluated.

<Electromagnetic wave shielding properties>

As shown in Fig. 11, each of the electromagnetic wave shielding members prepared in Examples 1 to 5 and Comparative Examples 1 to 3 was attached to an opening 480 mm × 480 mm of the middle partition wall of the two-room shield room using an attachment. The size of the exposed portion of the attached electromagnetic wave shielding member is 250 mm × 190 mm.

In addition, a transmitting antenna and a receiving antenna were each disposed at a distance of 1 m from the middle partition wall surface (an antenna spacing of 2 m) so as to obtain a shielding effect by approximately far-field plane wave.

As the transmitting antenna, a bilog antenna (CBL6140A, manufactured by Schaffner EMC Inc.) was used in the range of 30 MHz to 1000 MHz. In addition, a horn antenna (96001, manufactured by Raven Antenna Systems Inc.) was used in the range of 1 GHz to 18 GHz.

As the receiving antenna, a biconical antenna (manufactured by Fujitsu General EMC Laboratory Ltd.) was used in the range of 30 MHz to 1000 MHz. In addition, a horn antenna (9120D, manufactured by Schwarzbeck Mess-Elektronik oHG) was used in the range of 1 GHz to 18 GHz.

As a power amplifier, NA10MF3G2 (manufactured by Noise Laboratory Co., Ltd.) was used in the range of 30 MHz to 1000 MHz. In addition, 83017A (manufactured by Agilent Technologies, Inc.) was used in the range of 1 GHz to 18 GHz.

As a preamplifier, a preamplifier manufactured by Stack Electronics Co., Ltd. was used in the range of 30 MHz to 1000 MHz. In addition, 8449B (manufactured by HP) was used in the range of 1 GHz to 18 GHz.

R3770 (manufactured by Advantest Corporation) was used as a network analyzer (NA).

In order to define the electromagnetic wave shielding properties in the portion where the leakage of radio waves is the largest (the weakest portion of the shield), the receiving antenna was scanned over a range of ±240 mm in the center (480 mm × 480 mm) and the maximum level of field strength was recorded by the Max Hold function. The electromagnetic wave shielding properties were determined from the maximum level of the intensity of the electromagnetic wave before passing through the electromagnetic wave shielding member and the maximum level of the intensity of the electromagnetic wave after passing through the electromagnetic wave shielding member. The electromagnetic wave shielding properties were taken as the average value in the range of 1 GHz to 18 GHz with the state without the electromagnetic wave shielding member as a reference.

<Transmittance in ultraviolet region to visible light region>

The transmittance in the ultraviolet region to the visible light region of each of the electromagnetic wave shielding members prepared in Examples 1 to 5 and Comparative Examples 1 to 3 was measured.

The transmittance was measured using SolidSpec-3700 (manufactured by Shimadzu Corporation), and the average value of the measured values was determined.

<Transmittance in near-infrared region>

The transmittance in the near-infrared region of each of the electromagnetic wave shielding members prepared in Examples 1 to 5 and Comparative Examples 1 to 3 was measured.

The transmittance was measured using a spectrometer V-7200 (manufactured by JASCO Corporation), and the average value of the measured values was determined.

<Transmittance in mid-infrared region>

The transmittance in the mid-infrared region of each of the electromagnetic wave shielding members prepared in Examples 1 to 5 and Comparative Examples 1 to 3 was measured.

The transmittance was measured in the range of 2500 nm to 18000 nm using a Bluker FT-IR Vertex 70, and the average value of the measured values in the range from 2500 nm to a wavelength of half the length of the average opening diameter was determined.

The results are shown in Table 2.

[Table 2]

| | Metal foil | | | Evaluation | | | | | |
|---|---|---|---|---|---|---|---|---|---|
| | Through-hole | | Thickness μm | GHz band | Ultraviolet to visible | Near-infrared | Mid-infrared | | |
| | Average opening diameter μm | Average opening ratio % | | Shielding properties dB | Transmittance % | Transmittance % | Wavelength range nm | Transmittance % | Transmittance/ opening ratio % |
| Example 1 | 20 | 5 | 18.5 | 73 | 4 | 3 | 2500 to 10000 | 2 | 30 |
| Example 2 | 40 | 5 | 18.5 | 70 | 4 | 3 | 2500 to 18000 | 2 | 30 |
| Example 3 | 40 | 15 | 18.5 | 65 | 13 | 12 | 2500 to 18000 | 4 | 27 |
| Example 4 | 8 | 4 | 7.0 | 70 | 7 | 5 | 2500 to 4000 | 2 | 43 |
| Example 5 | 13 | 3 | 10.0 | 71 | 3 | 3 | 2500 to 6500 | 2 | 47 |
| Comparative Example 1 | 3 | 0.7 | 20.0 | 68 | 0 | 0 | - | 0 | 0 |
| Comparative Example 2 | 110 | 15 | 20.0 | 54 | 15 | 15 | 2500 to 18000 | 15 | 100 |
| Comparative Example 3 | 300 | 15 | 20.0 | 51 | 15 | 15 | 2500 to 18000 | 15 | 100 |

As shown in Table 2, Comparative Example 1 exhibited high shielding properties in the GHz band, but had no transmittivity in the ultraviolet region to the near-infrared region and the mid-infrared region. On the other hand, Comparative Examples 2 and 3 exhibited transmittivity in the ultraviolet region to the visible light region, the near-infrared region, and the mid-infrared region, but had low shielding properties in the GHz band.

On the other hand, it can be seen that Examples of the present invention are capable of achieving the shielding properties in the GHz band of 60 dB or more and are capable of securing the transmittance in the ultraviolet region to the visible light region, the transmittance in the near-infrared region, and the transmittance in the mid-infrared region.

From the above, the effects of the present invention are obvious.

Explanation of References

1: aluminum substrate

2: aluminum hydroxide film

3: metal foil with through-holes

4: aluminum hydroxide film with through-holes

5: through-hole

10: electromagnetic wave shielding member

12: metal foil

14: resin layer

16: metal particles

18: protective layer

## Claims

1. An electromagnetic wave shielding member comprising:

a metal foil formed with a plurality of through-holes penetrating therethrough in a thickness direction,
wherein the through-holes have an average opening diameter of 1 μm to 100 μm and an average opening ratio of 1% to 50%,
in a case where the average opening diameter of the through-holes is 1 μm or more and less than 1.5 μm,
the transmittance with respect to electromagnetic waves up to a wavelength of half the length of the average opening diameter of the through-holes from an ultraviolet region to a visible region is 10% or more of the average opening ratio,
in a case where the average opening diameter of the through-holes is 1.5 μm or more and less than 5 μm,
the transmittance with respect to electromagnetic waves from the ultraviolet region to the visible region is in a range of absolute value -5% to +5% of the average opening ratio of the through-holes,
the transmittance with respect to electromagnetic waves up to a wavelength of half the length of the average opening diameter of the through-holes in a near-infrared region is 10% or more of the average opening ratio,
in a case where the average opening diameter of the through-holes is 5 μm or more,
the transmittance with respect to electromagnetic waves from the ultraviolet region to the near-infrared region is in a range of absolute value -5% to +5% of the average opening ratio of the through-holes, and
the transmittance with respect to electromagnetic waves up to a wavelength of half the length of the average opening diameter of the through-holes in a mid-infrared region is 10% or more of the average opening ratio.

2. The electromagnetic wave shielding member according to claim 1,
wherein the metal foil has a thickness of 5 μm to 1000 μm.

**3.** The electromagnetic wave shielding member according to claim 1 or 2,
wherein the metal foil is a foil selected from the group consisting of an aluminum foil, a copper foil, a silver foil, a gold foil, a platinum foil, a stainless steel foil, a titanium foil, a tantalum foil, a molybdenum foil, a niobium foil, a zirconium foil, a tungsten foil, a beryllium copper foil, a phosphor blue copper foil, a brass foil, a nickel silver foil, a tin foil, a lead foil, a zinc foil, a solder foil, an iron foil, a nickel foil, a permalloy foil, a nichrome foil, a 42 alloy foil, a kovar foil, a monel foil, an inconel foil, and a hastelloy foil, or a foil obtained by laminating a foil selected from this group and a metal different from the selected foil.

**Amended claims under Art. 19.1 PCT**

**1.** An electromagnetic wave shielding member comprising:

a metal foil formed with a plurality of through-holes penetrating therethrough in a thickness direction,
wherein the through-holes have an average opening diameter of 1 μm to 45 μm and an average opening ratio of 1% to 50%,
in a case where the average opening diameter of the through-holes is 1 μm or more and less than 1.5 μm,
the transmittance with respect to electromagnetic waves up to a wavelength of half the length of the average opening diameter of the through-holes from an ultraviolet region to a visible region is 10% or more of the average opening ratio,
in a case where the average opening diameter of the through-holes is 1.5 μm or more and less than 5 μm,
the transmittance with respect to electromagnetic waves from the ultraviolet region to the visible region is in a range of absolute value -5% to +5% of the average opening ratio of the through-holes,
the transmittance with respect to electromagnetic waves up to a wavelength of half the length of the average opening diameter of the through-holes in a near-infrared region is 10% or more of the average opening ratio,
in a case where the average opening diameter of the through-holes is 5 μm or more,
the transmittance with respect to electromagnetic waves from the ultraviolet region to the near-infrared region is in a range of absolute value -5% to +5% of the average opening ratio of the through-holes, and
the transmittance with respect to electromagnetic waves up to a wavelength of half the length of the average opening diameter of the through-holes in a mid-infrared region is 10% or more of the average opening ratio.

**2.** The electromagnetic wave shielding member according to claim 1,
wherein the metal foil has a thickness of 5 μm to 1000 μm.

**3.** The electromagnetic wave shielding member according to claim 1 or 2,
wherein the metal foil is a foil selected from the group consisting of an aluminum foil, a copper foil, a silver foil, a gold foil, a platinum foil, a stainless steel foil, a titanium foil, a tantalum foil, a molybdenum foil, a niobium foil, a zirconium foil, a tungsten foil, a beryllium copper foil, a phosphor blue copper foil, a brass foil, a nickel silver foil, a tin foil, a lead foil, a zinc foil, a solder foil, an iron foil, a nickel foil, a permalloy foil, a nichrome foil, a 42 alloy foil, a kovar foil, a monel foil, an inconel foil, and a hastelloy foil, or a foil obtained by laminating a foil selected from this group and a metal different from the selected foil.

FIG. 1

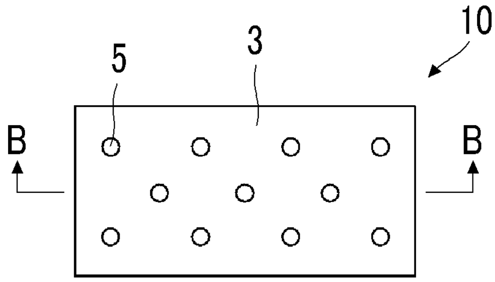


FIG. 2

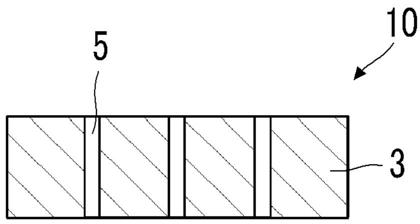


FIG. 3

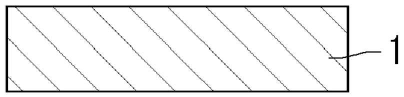


FIG. 4

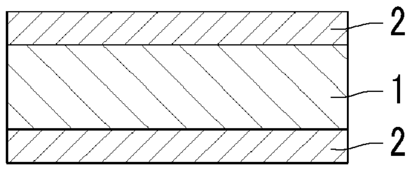


FIG. 5

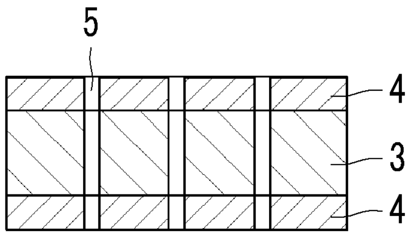


FIG. 6

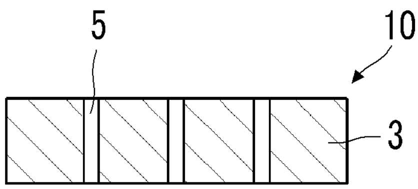

FIG. 7

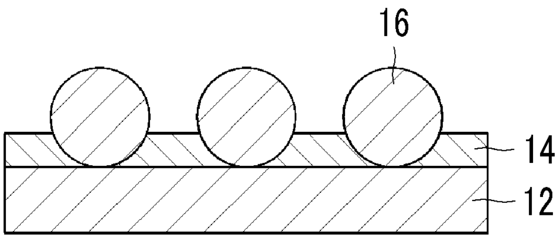


FIG. 8

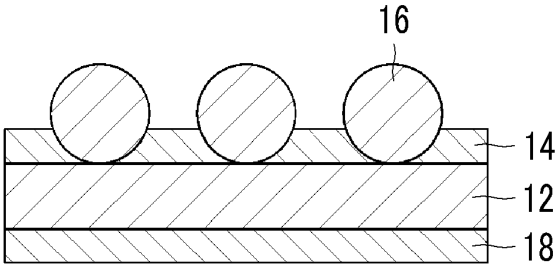


FIG. 9

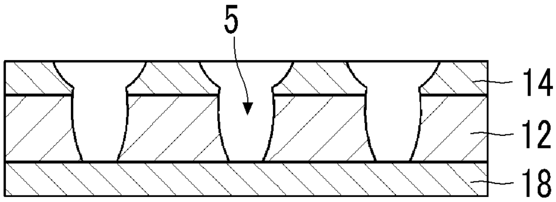


FIG. 10

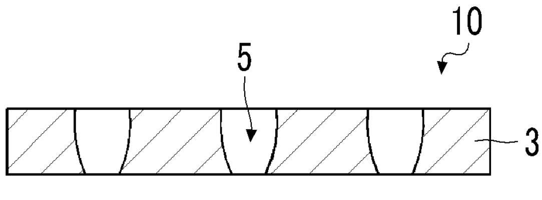


FIG. 11

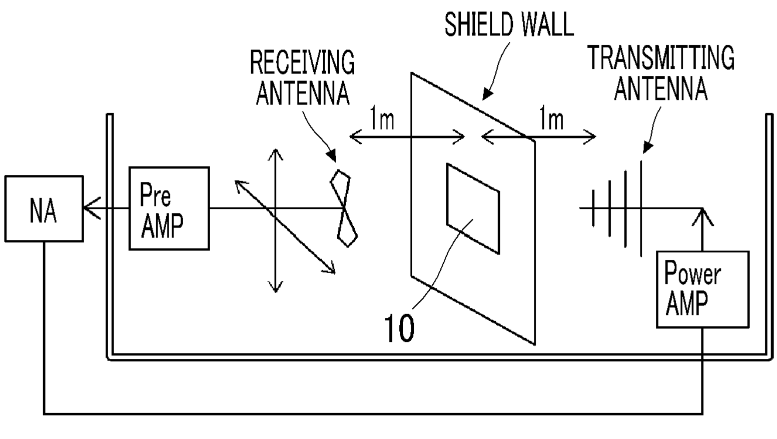

## INTERNATIONAL SEARCH REPORT

International application No. PCT/JP2018/009549

A. CLASSIFICATION OF SUBJECT MATTER
Int.Cl. H05K9/00(2006.01)i

According to International Patent Classification (IPC) or to both national classification and IPC

B. FIELDS SEARCHED

Minimum documentation searched (classification system followed by classification symbols)
Int.Cl. H05K9/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2015/115531 A1 (FUJIFILM CORPORATION) 06 August 2015, paragraphs [0019], [0060]-[0062], [0100], [0108] & US 2016/0294002 A1, paragraphs [0055]-[0058], [0170]-[0177], [0291] & EP 3101159 A1 | 1-3 |
| A | JP 2003-273575 A (TOKAI ALUMINUM FOIL CO., LTD.) 26 September 2003 (Family: none) | 1-3 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>11.05.2018 | Date of mailing of the international search report<br>22.05.2018 |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11177277 A
- JP H11177277 A
- JP 2009243138 A
- JP 2011201123 A
- US 4671859 A
- US 4661219 A
- US 4618405 A
- US 4600482 A
- US 4566960 A
- US 4566958 A
- US 4566959 A
- US 4416972 A
- US 4374710 A
- US 4336113 A
- US 4184932 A
- JP 62251740 A
- JP S62251740 A
- JP 3208514 A
- JP H03208514 A
- JP 59121044 A
- JP S59121044 A
- JP 4013149 A
- JP H04013149 A
- JP 2013121673 A
- WO 2008078777 A